Europäisches Patentamt

European Patent Office

Office européen des brevets

(19)

(11) **EP 0 992 810 A2**

(12) **EUROPÄISCHE PATENTANMELDUNG**

(43) Veröffentlichungstag:
**12.04.2000 Patentblatt 2000/15**

(51) Int. Cl.$^7$: **G01R 31/319**

(21) Anmeldenummer: **99117343.6**

(22) Anmeldetag: **03.09.1999**

(84) Benannte Vertragsstaaten:
**AT BE CH CY DE DK ES FI FR GB GR IE IT LI LU
MC NL PT SE**
Benannte Erstreckungsstaaten:
**AL LT LV MK RO SI**

(30) Priorität: **22.09.1998 DE 19843435**

(71) Anmelder:
**SIEMENS AKTIENGESELLSCHAFT
80333 München (DE)**

(72) Erfinder:
• **Lüpke, Jens
81829 München (DE)**
• **Weber, Frank
84559 Kraiburg/Inn (DE)**
• **Sillup, Joseph
81541 München (DE)**

(54) **Burn-In-Testvorrichtung**

(57) Die Erfindung betrifft eine Burn-In-Testvorrichtung für Halbleiterspeicher, bei der in einem Test-Board (100) Test-Sockel (101, 102, 103, 104, ...) einsetzbar sind, wobei das Test-Board (100) derart alternierend verdrahtet ist, daß Burn-In-Impulse abhängig von der Organisation an die Halbleiterbausteine anlegbar sind, so daß jeweils die Gesamtzahl der Eingangs/Ausgangsleitungen mit den Burn-In-Impulsen beaufschlagt ist.

**Fig. 2**

EP 0 992 810 A2

**Beschreibung**

Die vorliegende Erfindung betrifft eine Burn-In-Testvorrichtung für Halbleiterspeicher, mit einem Test-Board ("-Feld"), in welchem eine Vielzahl von Test-Sockeln zur Aufnahme von jeweils wenigstens einem Halbleiterbaustein vorgesehen ist, wobei an jedem Halbleiterbaustein Burn-In-Impulse anlegbar sind und jeder Halbleiterbaustein über einen gesonderten Anschluß ausschaltbar ist.

Burn-In-Tests ("Einbrenntests") werden bekanntlich durchgeführt, um schwache Halbleiterbausteine auszusondern, bevor diese in Schaltungen eingebaut werden. Dabei werden an die Eingänge der Halbleiterbausteine Burn-In-Impulse bzw. -Signale unter härteren Betriebsbedingungen angelegt, als diese beim normalen Betrieb des Halbleiterbausteins auftreten. Das heißt, die Burn-In-Tests werden unter höheren Temperaturen als den normalen Temperaturen für die Halbleiterbausteine und mit höheren Betriebsspannungen als den normalen Betriebsspannungen durchgeführt.

Burn-In-Tests werden bevorzugt an Halbleiterspeichern ausgeführt. Hier gibt es bekanntlich Speicher mit verschiedenen Organisationen, wie beispielsweise 64M DRAMs mit den Organisationen 4M x 16, 8M x 8 und 16M x 4. Dabei bedeuten "x 16", "x 8" und "x 4" die Anzahl der Eingangs/Ausgangsanschlüsse "DQ0, DQ1, DQ2, ..." des jeweiligen DRAMs. "4M", "8M" und "16M" gibt die jeweilige Speicherkapazität an. Ein DRAM "4M x 16" hat also 16 zu testende Eingangsanschlüsse.

Bisher wird nun so vorgegangen, daß abhängig von der Anzahl der Eingangsanschlüsse verschiedene Test-Boards verwendet werden. Das heißt, zum Testen eines Speichers der Organisation "4M x 16" wird ein anderes Test-Board als zum Testen eines Halbleiterspeichers der Organisation "8M x 8" eingesetzt. Alternativ ist es auch möglich, ein für Halbleiterspeicher der höchsten Organisation geeignetes Test-Board einzusetzen. Dann ist aber die Ausnutzung der Anschlußkapazität bei Halbleiterspeichern niedrigerer Organisation verringert.

Ein Test-Board hat beispielsweise 256 Sockel, die in 16 Zeilen und 16 Spalten matrixartig angeordnet sind. In jedem Sockel wird ein Baustein eingesetzt. Dabei werden im gesamten Test-Board jeweils die gleichen Bausteine mit "x 16" oder "x 8" oder "x 4" getestet, also Halbleiterspeicher, mit 16 bzw. 8 bzw. 4 Eingangsanschlüssen.

Unter Eingangs/Ausgangsanschlüssen sind dabei die Anschlüsse zu verstehen, über die auf das Zellenfeld zugegriffen wird. Diese Anschlüsse (Datenpins) werden, wie bereits oben angedeutet wurde, als "DQ" bezeichnet. An einem Halbleiterspeicher liegen noch andere Signale, wie beispielsweise Versorgungsspannung VDD, Massespannung VSS, Signale CDQM, $\overline{WE}$, $\overline{RAS}$, $\overline{CS}$, $\overline{CAS}$, Adressen A1, A2, ..., Adressen WA, Steuersignale LDQM, UDQM, DQM, CLK, CKE usw., wobei die einzelnen Halbleiterspeicher - damit sie in das gleiche Gehäuse eingebaut werden können - auch nicht angeschlossene ("NC") nach außen führende Pins ("Anschlußstifte") haben.

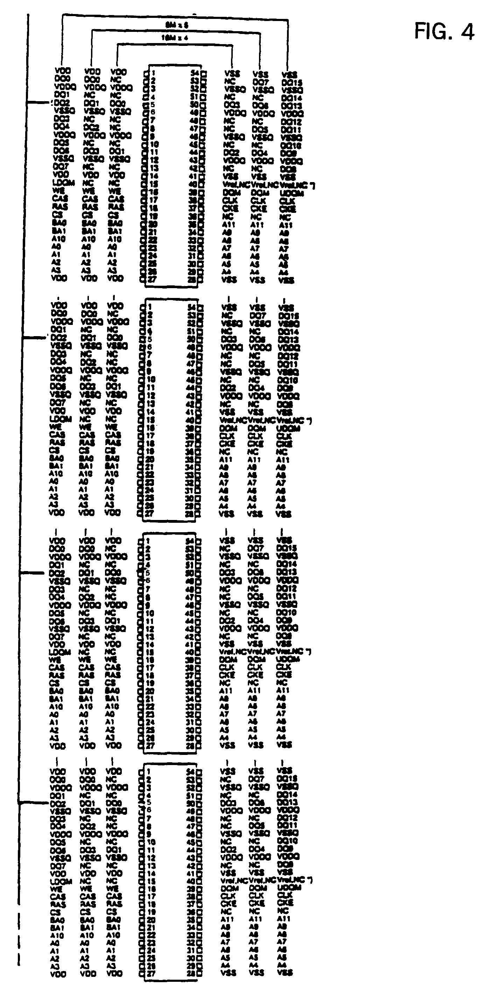

Fig. 4 zeigt, wie bisher Burn-In-Testvorrichtungen aufgebaut sind und arbeiten. Es sind hier vier Halbleiterspeicher gezeigt, die jeweils 54 Pins haben, an denen die oben genannten Signale bzw. Adressen usw. anliegen. Abhängig von der Organisation "16M x 4", "8M x 8" und "4M x 16" sind 4 bzw. 8 bzw. 16 Eingangs/Ausgangsanschlüsse DQ0, DQ1, DQ2, ... vorhanden. Dabei hat ein Halbleiterbaustein niedrigerer Organisation Eingangs/Ausgangsanschlüsse an den Stellen bzw. Pins, an denen auch ein Eingangs/Ausgangsanschluß eines Halbleiterspeichers höherer Organisation vorliegt. Beispielsweise ist der Pin 5 für alle Organisationen ein Eingangs/Ausgangsanschluß, während der Pin 2 ein Eingangs/Ausgangsanschluß nur für die Organisationen "x 8" bzw. "x 16" ist. Der Bin 13 ist lediglich für die Organisation "x 16" ein Eingangs/Ausgangsanschluß.

Bei den bestehenden Burn-In-Vorrichtungen wird nun so vorgegangen, daß jede Eingangsleitung unabhängig von der Organisation des zu testenden Speichers an jedem Sockel an demselben Bin kontaktiert, wie dies in Fig. 4 für den Bin "5" gezeigt ist. Das heißt, in dem gesamten Board sind alle beispielsweise 256 Sockel hier über die gleiche Eingangsleitung an dem Pin 5 kontaktiert. Wird nun in ein Test-Board, das für die Organisation "x 16" ausgelegt ist, ein Halbleiterspeicher mit der Organisation "x 8" oder "x4" eingesetzt, so führt dies zu einer Verdopplung oder Vervierfachung der Testzeit bei diesen Organisationen. Wird nämlich ein Halbleiterspeicher mit der Organisation "x 4" in einen Sockel eines Test-Boards der Organisation "x 16" eingesetzt, so liegen an den "NC-"Anschlüssen ebenfalls Testsignale an, die nicht genutzt wird. Da der Speicher einer Organisation "x4" viermal größer als der Speicher einer Organisation "x16" ist, kommt es zu einem Vervierfachen der Testzeit.

Diese Vervielfachung der Testzeit ist bisher nur dadurch zu umgehen, daß, worauf bereits oben hingewiesen wurde, für jede Organisation ein gesondertes Test-Board bereitgehalten wird, also Test-Boards für Organisationen "x 16", "x 8" und "x 4".

Es ist nun Aufgabe der vorliegenden Erfindung, eine Burn-In-Testvorrichtung zu schaffen, in deren Test-Board bzw. in dessen Sockel Halbleiterbausteine verschiedener Organisationen einsetzbar sind, wobei Vervielfachungen der Testzeit beim Testen von Halbleiterbausteinen niedrigerer Organisation zu vermeiden sind.

Diese Aufgabe wird bei einer Burn-In-Testvorrichtung der eingangs genannten Art erfindungsgemäß dadurch gelöst, daß im Test-Board die in die Test-Sockel einsetzbaren Halbleiterbausteine alternierend verdrahtet sind, so daß in das Test-Board Halbleiterbausteine unterschiedlicher aber in sich jeweils gleicher Organisation (also z.B. nur "x16" oder nur "x4") einsetzbar sind, wobei bei dieser Organisation jeder Halbleiterbaustein einer niedrigeren Organisation einen Pin einer zu testenden Eingangs/Ausgangsleitung an der Stelle eines Pins einer zu testenden Eingangs/Ausgangsleitung eines Halbleiterbausteins einer höheren Organisation hat und ein Halbleiterbaustein einer höheren Organisation wenigstens eine zu testende Eingangs/Ausgangsleitung mehr als ein Halbleiterbaustein einer niedrigeren Organisation aufweist, und die Burn-In-Impulse abhängig von der Organisation an den Halbleiterbaustein anlegbar sind, so daß die Gesamtzahl der Eingangs/Ausgangsleitungen mit den Burn-In-Impulsen beaufschlagt ist.

In einer Weiterbildung der Erfindung ist vorgesehen, daß die Eingangs/Ausgangsleitungen alternierend mit einer Periode

$$m = 1 + M/n$$

verdrahtet sind, wobei M die größte Organisationsbreite, beispielsweise "x 16", und n die kleinste Organisationsbreite, beispielsweise "x 4", bedeuten. Für das obige Beispiel mit Organisationen "x 4", "x 8" und "x 16" ergeben sich M = 16 und n = 4, so daß sich insgesamt m = 5 folgt. Das heißt, jeder fünfte Halbleiterspeicher wird in dem Test-Board in den Test-Sockeln am jeweils gleichen Pin angeschlossen. Das heißt, es sind jeweils vier Bausteine in einer bestimmten Art verdrahtet, wobei sich das so entstehende Vierer-Muster wiederholt, so daß der fünfte Baustein gleich wie der erste verdrahtet ist.

Durch dieses Verdrahtungsprinzip ist es möglich, beim Burn-In-Test für alle möglichen Organisationen stets die Gesamtzahl der Eingangs/Ausgangsleitungen - angepaßt an die jeweilige Organisation - zu nutzen und damit die Testzeit zu minimieren. Wesentlich an der Erfindung ist also die alternierende Verdrahtung der Halbleiterbausteine im Test-Board der Burn-In-Testvorrichtung anstelle der bisher üblichen und in Fig. 4 gezeigten gleichartigen Verdrahtung am jeweils gleichen Pin.

Nachfolgend wird die Erfindung anhand der Zeichnungen näher erläutert.

Es zeigen:

Fig. 1 eine schematische Darstellung eines Test-Boards der erfindungsgemäßen Burn-In-Testvorrichtung,

Fig. 2 schematisch die Verdrahtung von vier Test-Sockeln bei dem Board von Fig. 1,

Fig. 3 die Verdrahtung von vier 64M-Halbleiterspeichern bei der erfindungsgemäßen Burn-In-Testvorrichtung und

Fig. 4 die Verdrahtung von vier 64M-Halbleiterspeichern in einer bestehenden Burn-In-Testvorrichtung.

Die Fig. 4 ist bereits eingangs erläutert worden. In den Figuren werden für einander entsprechende Bauteile jeweils die gleichen Bezugszeichen verwendet.

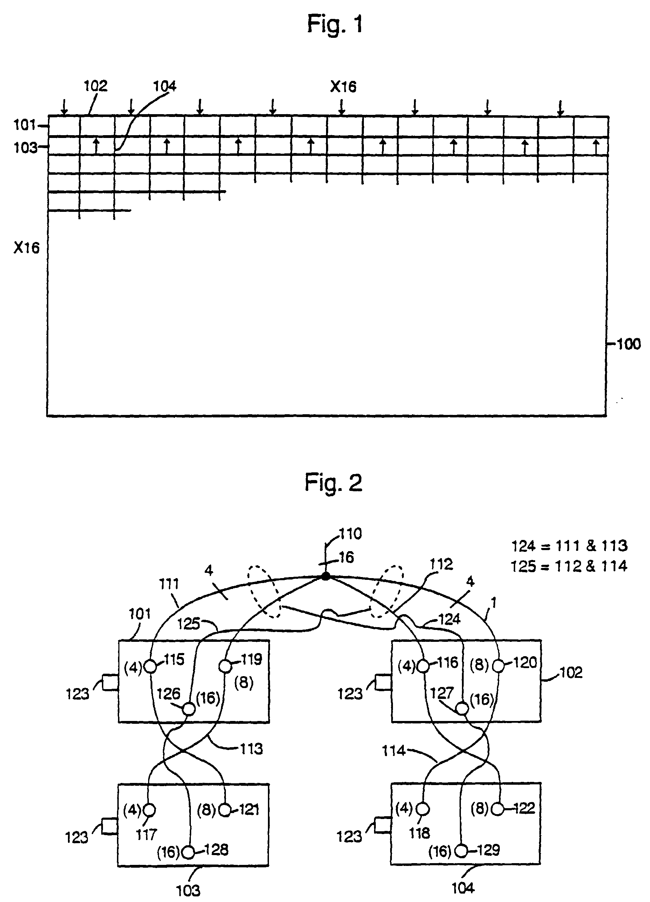

Fig. 1 zeigt schematisch ein Test-Board 100, in welchem matrixartig 16 x 16 = 256 Test-Sockel angeordnet sind, von denen vier Test-Sockel 101, 102, 103 und 104 gesondert mit Bezugszeichen versehen sind. In diese Test-Sockel wird jeweils ein Halbleiterbaustein, insbesondere ein Halbleiterspeicher, eingesetzt, so daß insgesamt 256 Halbleiterbausteine einem Burn-In-Test unterworfen werden können.

Im folgenden wird davon ausgegangen, daß die zu testenden Halbleiterbausteine solche von der Organisation "x16" sind.

In einem ersten Neßzyklus wird beispielsweise an jeden zweiten Halbleiterbaustein der ersten Zeile ein Testsignal angelegt, während die verbleibenden Halbleiterbausteine dieser ersten Zeile sodann einem zweiten Testzyklus unterworfen werden, wie dies in der Fig. 1 durch eine obere Pfeilreihe für den ersten Testzyklus und durch eine in dieser Figur untere Pfeilreihe für den zweiten Testzyklus der Halbleiterbausteine dieser ersten Zeile, beginnend mit dem Test-Sockel 101, angedeutet ist. Auf diese Weise können alle 256 Halbleiterbausteine in 32 Testzyklen getestet bzw. gemessen werden.

Fig. 2 zeigt nun schematisch die Verdrahtung der ersten vier Test-Sockel 101, 102, 103 und 104 in dem Test-Board 100. Hier sind 16 Eingangsleitungen 110 zunächst in jeweils 4 x 4 Leitungen 111, 112, 113, 114 verzweigt, die zu Anschlüssen 115, 116, 117 und 118 für Pins eines Halbleiterspeichers einer "x 4"-(oder "x 8"- oder "x 16"-)Organisation führen. Bei Halbleiterspeichern einer "x 4"-Organisation können so mit einem Testzyklus 32 Halbleiterbausteine gleichzeitig getestet werden, so daß mit 8 Testzyklen die Halbleiterbausteine des gesamten Test-Boards 100 zu testen sind.

Um ein Testen von Halbleiterbausteinen einer "x 8"-Organisation zu ermöglichen, sind die Leitungen 111 bis zu dem Test-Sockel 103 geführt, und die Leitungen 112 erstrecken sich bis zu dem Test-Sockel 104. In ähnlicher Weise sind bei den Leitungen 113, 114 Anschlüsse auch für die Test-Sockel 101 und 102 vorgesehen. Es werden so Anschlüsse 119, 120, 121 und 122 für Pins von Halbleiterbausteinen einer "x 8"-Organisation geschaffen. Da nun die Leitungen 111, 112, 113 und 114 zu jeweils zwei Anschlüssen (beispielsweise 115 und 121 für die Leitung 111) führen, werden bei einem Test der Halbleiterbausteine der ersten Zeile die Halbleiterbausteine der zweiten Zeile, also die Halbleiterbausteine in den Test-Sockeln 103 und 104, ausgeschaltet, was durch Anlegen eines Signales DQM = "1" an gesonderte Anschlüsse 123 geschehen kann. Durch Beaufschlagen der jeweiligen Anschlüsse 123 mit diesem Signal "1" können so die jeweiligen Halbleiterbausteine in den entsprechenden Test-Sockeln ausgeschaltet werden, so daß sichergestellt ist, daß jeweils von einer Leitung 111, 112, 113 und 114 nur ein Halbleiterbaustein mit einem Testsignal beaufschlagt wird. Mit einem Testzyklus lassen sich so 16 Halbleiterbausteine gleichzeitig testen, so daß mit 16 Testzyklen alle Halbleiterbausteine des gesamten Test-Boards 100 getestet sind.

Zum Testen von Halbleiterbausteinen einer "x 16"-Organisation sind noch jeweils für jeden Test-Sockel acht zusätzliche Leitungen erforderlich. Hierzu werden die Leitungen 111, 113 der Test-Sockel 101, 103 zu den Test-Sockeln 102, 104 durch Leitungen 124 verzweigt. Umgekehrt werden auf die Leitungen 112, 118 der Test-Sockel 102, 104 in Leitungen 125 für die Test-Sockel 101, 103 verzweigt. Es entstehen so Anschlüsse 126, 127, 128, 129 für Pins von Halbleiterbausteinen einer "x 16"-Organisation.

Die Leitung 111 darf z.B. bei der "x4"-Organisation an den Test-Sockeln 103, 102, 104 nicht angeschlossen ("NC") und bei der "x8"-Organisation an den Test-Sockeln 102, 104 nicht angeschlossen ("NC") sein.

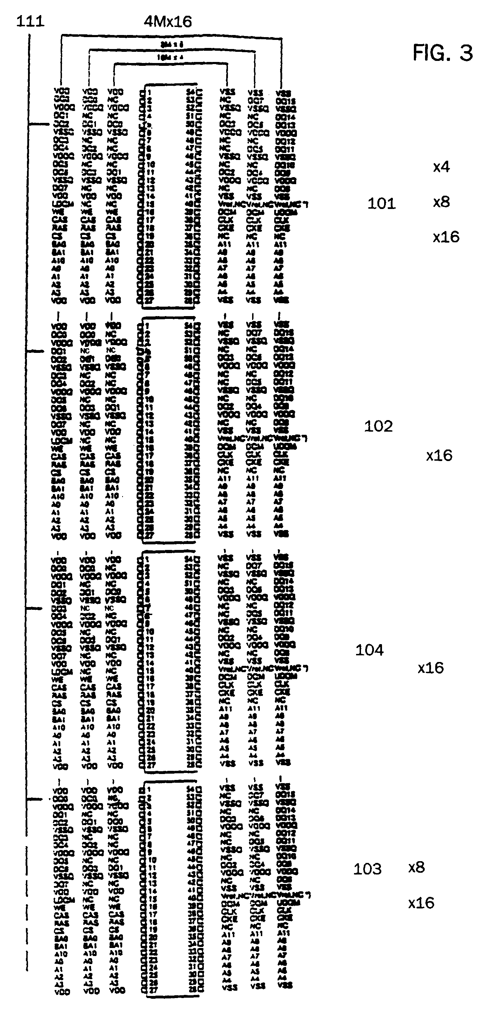

In Fig. 3 sind die Halbleiterbausteine in den Sockeln 101, 102, 104 und 103 von oben nach unten mit ihren jeweiligen Anschlüssen dargestellt. Ein Vergleich mit Fig. 4 zeigt sofort, daß hier im Unterschied zu der gleichartigen Kontaktierung der Pins mit der Eingangsleitung eine alternierende Verdrahtung der Halbleiterbausteine auf dem Burn-In-Board vorliegt, die es ermöglicht, nur die Pins der Halbleiterbausteine mit Test-Impulsen zu beaufschlagen, die tatsächlich mit einer Eingangs/Ausgangsleitung ("DQ") verbunden sind. Damit ist eine erhebliche Reduzierung der Testzeit möglich, wobei in die einzelnen Test-Sockel 101, 102, 103, 104 usw. eines Test-Boards Halbleiterbausteine unterschiedlicher Organisation einsetzbar sind.

**Patentansprüche**

1. Burn-In-Testvorrichtung für Halbleiterbauelemente, mit einem Test-Board (100), in welchem eine Vielzahl von Test-Sockeln (101, 102, 103, 104 ...) zur Aufnahme von jeweils wenigstens einem Halbleiterbaustein vorgesehen ist, wobei an jeden Halbleiterbaustein Burn-In-Impulse anlegbar sind und jeder Halbleiterbaustein über einen gesonderten Anschluß (DQM) ausschaltbar ist,
**dadurch gekennzeichnet,**
daß im Test-Board (100) die in die Test-Sockel (101, 102, 103, 104, ..,) einsetzbaren Halbleiterbausteine alternierend verdrahtet sind, so daß in das Test-Board (100) Halbleiterbausteine unterschiedlicher Organisation einsetzbar sind, wobei bei dieser Organisation jeder Halbleiterbaustein einer höheren Organisation einen Pin einer zu testenden Eingangs/Ausgangsleitung an der Stelle eines Pins einer zu testenden Eingangs/Ausgangs

leitung eines Halbleiterbausteins einer niedrigeren Organisation hat und ein Halbleiterbaustein einer höheren Organisation wenigstens eine zu testende Eingangs/Ausgangsleitung mehr als ein Halbleiterbaustein einer niedrigen Organisation aufweist, und die Burn-In-Impulse abhängig von der Organisation an den Halbleiterbaustein anlegbar sind, so daß die Gesamtzahl der Eingangs/Ausgangsleitungen mit den Burn-In-Impulsen beaufschlagt ist.

2. Burn-In-Testvorrichtung nach Anspruch 1,
**dadurch gekennzeichnet,**
daß die Eingangs/Ausgangsleitungen alternierend mit einer Periode

$$m = 1 + M/n$$

verdrahtet sind, wobei M die größte Organisationsbreite (x 16) und n die kleinste Organisationsbreite (x 4) bedeuten.

# Fig. 1

# Fig. 2

124 = 111 & 113
125 = 112 & 114

FIG. 3

111     4Mx16

101     x4
        x8
        x16

102     x16

104     x16

103     x8
        x16

# FIG. 4